# EUROPEAN PATENT APPLICATION

(11) **EP 3 945 548 A1**
(43) Date of publication of application: **02.02.2022**
(21) Application number: 20188698.3
(22) Date of filing: 30.07.2020
(51) Int. Cl.: H01L 21/66, G03F 7/20, G05B 19/418, G05B 23/02

(54) **METHOD FOR CLASSIFYING SEMICONDUCTOR WAFERS**

(71) Applicant: ASML Netherlands B.V., 5500 AH Veldhoven (NL)
(72) Inventor: GKOROU, Dimitra, 5500 AH Veldhoven (NL); BASTANI, Vahid, 5500 AH Veldhoven (NL); SAHRAEIAN, Reza, 5500 AH Veldhoven (NL); TABERY, Cyrus, Emil, San Jose, CA 95131 (US)
(74) Representative: ASML Netherlands B.V.

(57) **Abstract**

Methods and apparatus for classifying semiconductor wafers. The method comprises: sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics; identifying one or more semiconductor wafers within a sub-set based on a probability of the one or more semiconductor wafers being correctly allocated to the sub-set; comparing the parameter data of the one or more identified semiconductor wafers to reference parameter data; and reconfiguring the model based on the comparison. The comparison is undertaken by a human to provide constraints for the model. The apparatus is configured to undertake the method.

## Description

### FIELD

The invention relates to methods and associated apparatus for classifying semiconductor wafers. More specifically, the invention may relate to methods of classifying semiconductor wafers for diagnostics, monitoring and/or predicting future fabrication performance.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. Also, yield tests may be undertaken on specific areas of a semiconductor wafer, for example on individual dies. Typically, a series of separate yield tests are applied in a sequential way.

Measurements and/or yield tests may provide parameter data for a wafer. A model, which may employ machine learning algorithms, may then sort a set of wafers into a plurality of sub-sets based on the parameter data, which can allow diagnostics, monitoring and performance predictions of a fabrication process.

### SUMMARY

The inventors have appreciated that greater accuracy is desirable when a model is sorting wafers into subsets. Further, the parameter data, e.g. yield data, may be used to investigate specific features and/or areas of a wafer and/or features of a fabrication process that may be of interest. Methods and apparatus disclosed herein may be directed towards addressing those problems and/or other problems in the art that will be known to a skilled person.

According to the invention in an aspect, there is provided a method for classifying semiconductor wafers, the method comprising: sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics; identifying one or more semiconductor wafers within a sub-set based on a probability of the one or more semiconductor wafers being correctly allocated to the sub-set; comparing the parameter data of the one or more identified semiconductor wafers to reference parameter data; and reconfiguring the model based on the comparison.

Optionally, the method further comprises re-sorting at least part of the set of semiconductor wafers based on the reconfigured model.

Optionally, the reference parameter data comprises the common characteristics of the parameter data associated with the sub-set and/or parameter data of one or more further semiconductor wafers in the set of semiconductor wafers.

Optionally, the reference data comprises the common characteristics of the parameter data associated with the sub-set, and wherein the comparison comprises identifying a part of the parameter data of the identified semiconductor wafers that provides a stronger indication that the identified semiconductor wafers should or should not be allocated to the sub-set than at least one further part of the parameter data.

Optionally, the part of the parameter data wafers that provides a stronger indication comprises a part which must be present in the parameter data for an identified semiconductor wafer to be allocated to the sub-set and/or a part which must not be present in the parameter data for an identified semiconductor wafer to be allocated to the sub-set.

Optionally, identifying the part of the parameter data comprises receiving an input from a human indicating whether the identified semiconductor wafers should be allocated to the sub-set.

Optionally, the reference data comprises the parameter data of two further semiconductor wafers in the set of semiconductor wafers.

Optionally, the comparison comprises determining a separation between a sub-set of the parameter data of at least one of the one or more identified semiconductor wafers and corresponding sub-sets of the parameter data of the two further semiconductor wafers.

Optionally, the comparison comprises determining a relative separation between the sub-set of the parameter data of the at least one of the one or more identified semiconductor wafers and the corresponding sub-sets of the parameter data of the two further semiconductor wafers.

Optionally, the sub-set of the parameter data of the at least one of the one or more identified semiconductor wafers relates to a region and/or feature of interest of a semiconductor wafer.

Optionally, the comparison comprises receiving an indication from a human of which sub-set of the parameter data of the two further semiconductor wafers is closer to the sub-set of the parameter data of at least one of the one or more identified semiconductor wafers.

Optionally, the method further comprises determining the probability of the one or more semiconductor wafers being correctly allocated to the sub-set.

Optionally, determining the probability comprises determining a separation of at least part of the parameter data for a semiconductor wafer from the common characteristics of the sub-set.

Optionally, the sub-set comprises a further sub-set.

Optionally, the parameter data comprises yield data associated with a plurality of areas on the set of semiconductor wafers.

Optionally, the yield data has been determined by sequentially undertaking a plurality of tests on the plurality of areas.

Optionally, the yield data comprises data indicative of which of the plurality of tests has been passed and/or failed by the plurality of areas.

Optionally, the yield data comprises data indicative of a repair density for one or more of the plurality of areas to pass one or more of the plurality of tests.

Optionally, the common characteristics comprise a common yield data pattern relating to the plurality of areas on at least part of the semiconductor wafer.

Optionally, the common yield data pattern corresponds to a yield data pattern of at least a threshold number of the set of semiconductor wafers.

Optionally, the common yield data pattern corresponds to a yield data pattern of a semiconductor wafer in the set of semiconductor wafers if a separation of the common yield data pattern from the yield data pattern is less than a threshold separation value.

Optionally, the areas comprise one or more dies.

Optionally, the model is arranged to determine the plurality of sub-sets and/or the common characteristics of a sub-set based on the parameter data.

Optionally, the model comprises a machine learning algorithm.

Optionally, the comparing is undertaken by human.

According to the invention in an aspect, there is provided a computer program comprising instructions which, when executed on at least one processor, cause the at least one processor to control an apparatus to carry out the method according to any disclosed herein.

According to the invention in an aspect, there is provided a carrier containing the computer program, wherein the carrier is one of an electronic signal, optical signal, radio signal, or non-transitory computer readable storage medium.

According to the invention in an aspect, there is provided an apparatus for classifying semiconductor wafers, the apparatus comprising one or more processors configured to execute computer program code to undertake the method of: sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics; identifying one or more semiconductor wafers within a sub-set based on a probability of the one or more semiconductor wafers being correctly allocated to the sub-set; comparing the parameter data of the one or more identified semiconductor wafers to reference parameter data; and reconfiguring the model based on the comparison.

According to the invention in an aspect, there is provided a lithographic apparatus comprising the apparatus.

According to the invention in an aspect, there is provided a litho-cell comprising the lithographic apparatus.

According to the invention in an aspect, there is provided a method for classifying semiconductor wafers, the method comprising: sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics; identifying one or more semiconductor wafers within the set based on a probability that the one or more semiconductor wafers should be allocated to a further sub-set; comparing the parameter data of the one or more identified semiconductor wafers to reference parameter data; and reconfiguring the model based on the comparison.

According to the invention in an aspect, there is provided an apparatus for classifying semiconductor wafers, the apparatus comprising one or more processors configured to execute computer program code to undertake the method of: sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics; identifying one or more semiconductor wafers within the set based on a probability that the one or more semiconductor wafers should be allocated to a further sub-set; comparing the parameter data of the one or more identified semiconductor wafers to reference parameter data; and reconfiguring the model based on the comparison.

### Brief description of drawings

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 depicts a schematic representation of holistic lithography, representing a cooperation between three key technologies to optimize semiconductor manufacturing;
Figures 4a and 4b depict a flow charts of exemplary methods for classifying semiconductor wafers;
Figure 5 shows an example of a data driven determination of a plurality of sub-sets based on yield data;
Figure 6 shows a schematic example of a user interface; and
Figure 7 shows a schematic representation of a user interface.

### Detailed description

Generally, disclosed herein are methods and apparatus for classifying semiconductors. The classification may be based on parameter data, such as yield data, although other parameters may also be used. In the example of yield data, a model, which may be a machine learning model, classifies a set of semiconductor wafers based on yield data for the set. The wafers within a sub-set include a yield data pattern that corresponds, at least partially, to a common yield data pattern for the sub-set. This common yield data pattern may be termed common characteristics of the sub-set or a fingerprint of the sub-set. One or more wafers may be identified for query based on a separation between the yield data pattern of those wafers and the fingerprint for the sub-set. For example, those wafers at or near the edges of a sub-set may be identified. In one embodiment, the yield data pattern of the identified wafers may be compared to the fingerprint of an appropriate sub-set for confirming whether the wafer should or should not be in the sub-set. In another embodiment, the yield data pattern of the identified wafers may be compared to the yield data pattern of at least two further wafers in the set. The comparison may be based on input from a human operator or engineer. The model may then be reconfigured based on the comparison. In the case of a machine learning algorithm, the comparison may be used in a semi-supervised learning process.

Before describing embodiments of the methods and apparatus disclosed herein, there follows a general description of example environments in which one or more of those embodiments may be implemented.

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

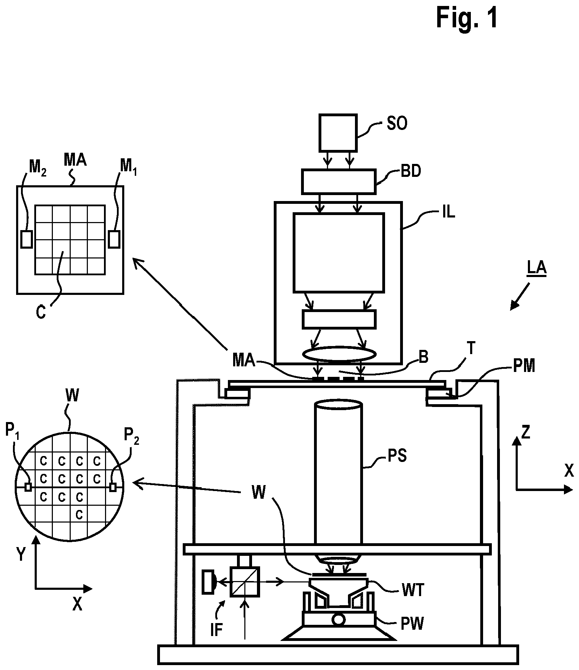

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

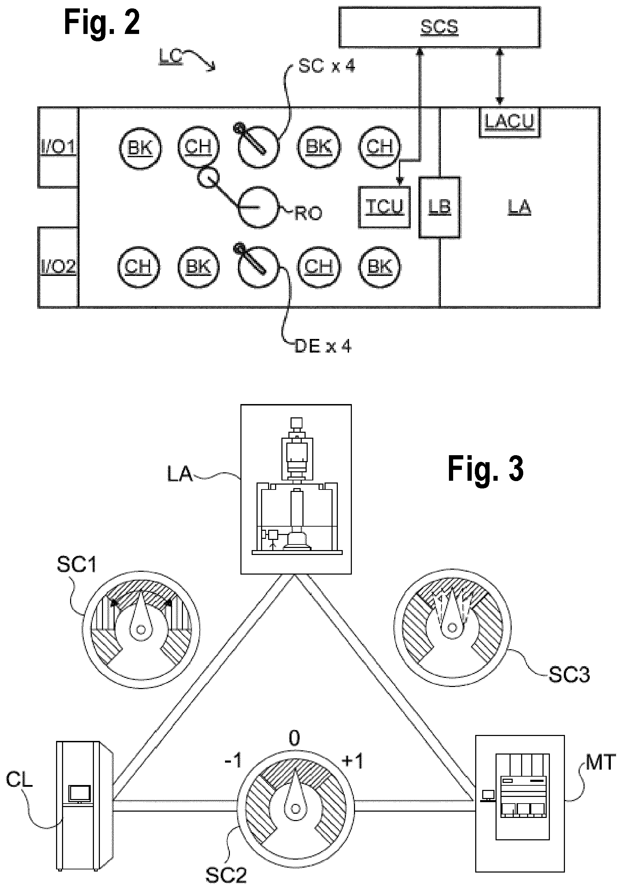

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1628164A, incorporated herein by reference in their entirety. Aforementioned scatterometers may measure gratings using light from soft x-ray, extreme ultraviolet and visible to near-IR wavelength range.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Exemplary arrangements of the methods and apparatus disclosed herein are now described in detail. An exemplary arrangement relating to yield data is discussed, but the skilled person will understand that other parameter data may be used. For example, the methods and apparatus disclosed herein may be arranged to operate using parameter data comprising overlay, CD or any other type of semiconductor metrology data.

The metrology tool MET may be arranged to perform yield tests on semiconductor wafers that have been patterned in the lithography apparatus LA. Such yield tests may be undertaken at die level. The results of a yield test may be represented as binary pass/fail values, or may be presented as a count (density) of a number of repairs applied to a die in order for it to pass the test.

The yield data may be the output from a plurality of yield tests undertaken in a sequential manner on a specific area of a semiconductor wafer, such as a die. Results for one of the plurality of yield tests are placed in a 'bin' having its own code, the so-called bin code. In some arrangements, a test may be conducted on a plurality of dies and the results of the test are placed in the bin having the bin code relating to that test. Following the introduction of redundancy on memory device cells, if a die fails on one test, repairs may be applied to it up to a particular capacity. If that capacity is exceeded, the die is considered to fail the tests. Once a die fails a test, no further tests in the series are applied to it. As used herein, the term "yield data" encompasses a binary pass/fail value, a repair count (or density) needed for a wafer to pass a test and/or the bin code that a die failed. Yield data may be visualised as a map or pattern showing the yield data for a plurality of fields, dies across one or more? semiconductor wafer.

Sorting wafers into sub-sets or groups, each having common characteristics or a common fingerprint, is useful for diagnostics, monitoring and yield predictions on a per wafer basis. Despite the advantages, most current fingerprint-based wafer classification methods have a number of problems associated with them that will be understood by the skilled person.

Algorithms used for allocating wafers to a sub-set based on parameter data, such as a yield data fingerprint, represent "ill-posed problems" as there is no ground truth available. Typically, clustering algorithms are based on one or more machine learning techniques or algorithms, which require adequate training data to operate with the necessary degree of accuracy. Training of such machine learning algorithms is improved if the training data used includes ground truth data (e.g. train to truth), but in examples mentioned herein no ground truth data is known and the training data is unlikely to yield well defined clusters.

In clustering algorithms, the results may depend on the choice of algorithm, hyperparameters, or even random seeds used for training. In addition, it is not guaranteed that the solution exists, e.g. if you are conducting clustering analysis, there is no guarantee that the data can be clustered. Clustering algorithms attempt to find some clusters given any data, but that does not mean that there is any real cluster to be found. To mitigate this in exemplary arrangements disclosed herein, a group may be defined by a human, who is a domain expert and so it is guaranteed that a valid group exists. The domain expert may further define indirectly the "rules" for a wafer belonging to this group.

Running a clustering algorithm to an embedding or other relevant representation of yield wafer maps may result in "noisy" sub-sets; a considerable amount of wafers may be assigned to a cluster, but having a relatively high degree of uncertainty of being correctly assigned to said cluster. The reasons for this might be that the yield data is affected by temporal; drifts, random defects and/or defects that have multiple root causes.

The quality of the training data used for machine learning may therefore be degraded, decreasing the performance of monitoring, predictions, and root cause recommendations. In addition, in the case of overlapping sub-sets, it might be unclear how to label wafers belonging to two groups. Further, it might be desirable to group wafers not only based on yield wafer maps but also based on information that is complementary to yield wafer maps, for example process similarity. In some arrangements, the prior knowledge of a yield engineer on the importance of particular wafer zones, fields, or a particular area on the wafer might be captured.

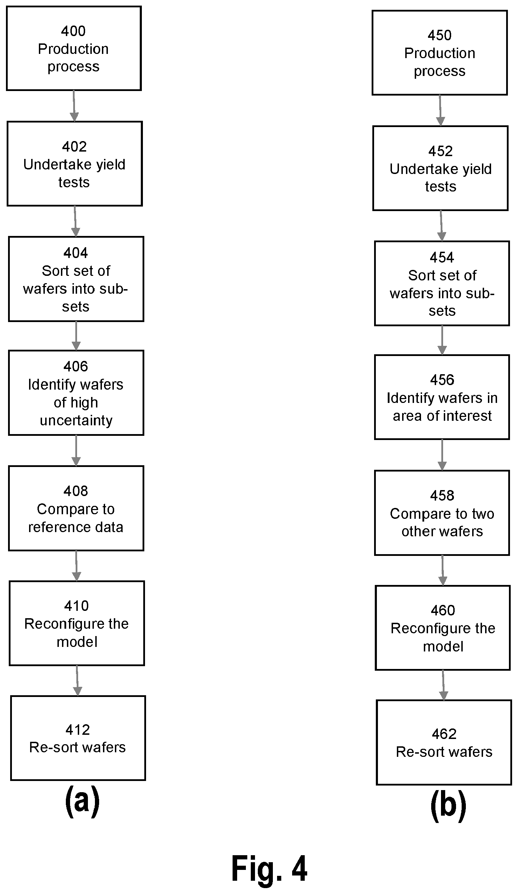

Figures 4a and 4b show flow charts of exemplary methods for classifying semiconductor wafers. Generally, Figure 4a shows an exemplary method for more accurate classification of wafers into sub-sets determined by a model, and Figure 4b shows an exemplary method for determining a new sub-set and classifying wafers into that new sub-set. A new sub-set may be determined, for example, to focus on an area or feature of interest that is conceptual and not directly derivable by a model from the yield data.

Referring to Figure 4a, a production process 400 is undertaken to fabricate a plurality of structures onto a set of semiconductor wafers. The production process is well known to the skilled person and an exemplary production process is described above.

A series of yield tests are undertaken 402 on the set of wafers. The yield tests produce parameter data, which in this case is yield data although other types of parameter data may be used. The yield data may be visualised as a yield data map or pattern corresponding to each of the set of wafers. The yield data map or pattern may comprise bin data (pass, fail or repair density) for a plurality of dies fabricated on a semiconductor wafer.

The set of wafers is sorted into a plurality of sub-sets 404. Sorting wafers into these sub-sets may be undertaken by a model, which may comprise a machine learning algorithm. The model may be configured to sort the set of wafers into sub-sets based on the closeness of the yield data for a wafer to common characteristics of yield data for a given sub-set.

The common characteristics for a sub-set may be termed a "fingerprint". The common characteristics may comprise a yield data pattern over at least part of a semiconductor wafer. A fingerprint of a sub-set may comprise a common pattern of yield data across the wafers in the sub-set (e.g. centroid, average fingerprint, medoid etc). For example in diagnostics, a machine learning algorithm may try to predict if a fingerprint is present on a wafer. The ranking of features depends on the ability of the machine learning algorithm to discriminate between wafers that belong to a particular sub-set versus other sub-sets. The corresponding features are ranked according to their association with group fingerprints. High ranked features might be indicative of root causes or paths for further exploration. The layer to which a yield fingerprint correlates may also be of importance for diagnostics. In monitoring applications, yield predictions at a wafer level can be used to check if the yield of a wafer deviates from the expected fingerprint of a product. Accordingly, the model may be configured to assign (or sort) a wafer to one or more sub-sets based on a similarity of the yield data for the wafer to the common characteristics of one or more sub-sets.

In exemplary arrangements, the model may be configured to determine the sub-sets and the common characteristics for the subsets based on the yield data for the set of semiconductor wafers. That is, the model may be configured to determine the common characteristics and optionally to determine a threshold, or boundary of a sub-set, that threshold or boundary comprising a maximum separation of yield data for a wafer from the yield data forming the common characteristics. The model may comprise any low-dimensionality embedding algorithm. In exemplary arrangements, the model may comprise a blind data driven method, such as Principal Component Analysis (PCA), autoencoder, t-distributed Stochastic Neighbour Embedding (t-SNE) and/or Uniform Manifold Approximation and Projection (UMAP).

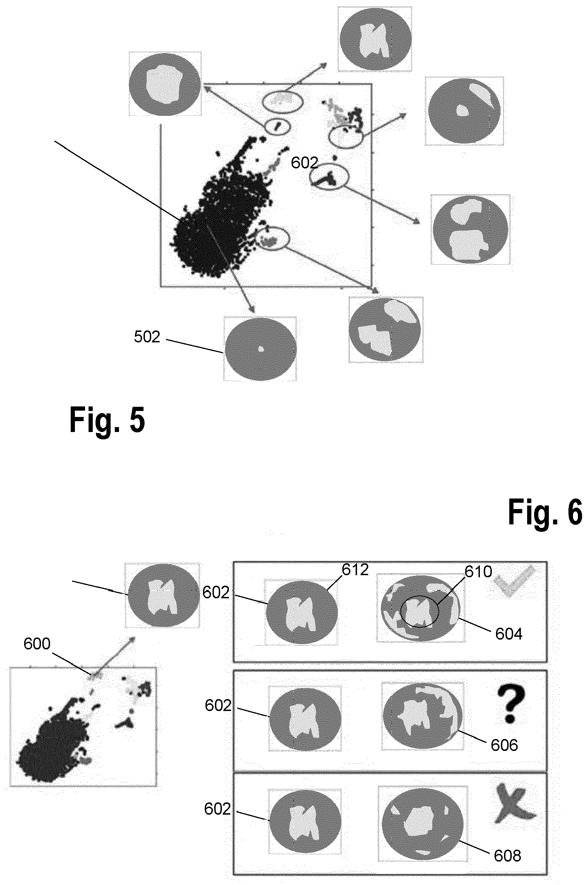

Figure 5 shows an example of a data driven determination of a plurality of sub-sets based on yield data. A plurality of sub-sets is shown, along with the corresponding common characteristics. For example a sub-set 500 corresponds to common characteristics (or fingerprint) 502, which comprises a yield wafer map.

One or more wafers are identified based on a probability that they have been correctly allocated to a sub-set. In the exemplary method of Figure 4a, wafers are identified 406 that have a high probability of incorrect allocation, or a high uncertainty over their allocation. The probability of a wafer being correctly allocated to a sub-set may be determined based on a separation of the yield data for the wafer from the common characteristics of the yield data for the sub-set. The greater the separation, the higher the probability that the wafer is incorrectly allocated to the sub-set. Put another way, the closer that the yield data for the wafer is to the conditions at the boundary of the sub-set, the higher the probability that the wafer has been incorrectly allocated to the sub-set. In exemplary arrangements, a separation threshold may be determined for one or more sub-sets setting a separation from the common characteristics of the corresponding sub-set. Wafers allocated to a sub-set at or beyond the separation threshold may be identified as having a high uncertainty over their allocation.

The identified wafers are compared to reference data 408. In exemplary arrangements, this comparison is undertaken by a human, who may be an expert in analysis of semiconductors and, in particular, of analysis of the parameter data being used (in this case, yield data). The model may be reconfigured based on the input of the human in a semi-supervised learning algorithm.

In one embodiment the reference data comprises the common characteristics of the sub-set to which the wafer has been allocated. A yield data map for the wafer and a yield data map for the common characteristics are presented to a human, such as a yield data engineer. In other exemplary arrangements, the reference data may comprise parameter data from a wafer within the sub-set, for example a wafer having a high probability of being accurately allocated to the sub-set. This may be termed a 'pairwise' constraint that may be used by the machine learning algorithm. Figure 6 shows a schematic example of a user interface in which the human can undertake the comparison and provide further information for sorting to the model.

A sub-set 600 determined by the model is associated with a yield wafer map 602 corresponding to the common characteristics for the sub-set. The yield wafer map 602 is presented to the human alongside yield wafer maps 604, 606, 608 for the wafers identified at 406. The human indicates whether the wafer should or should not be allocated to the sub-set. The human, based on prior knowledge, is able to identify areas of the yield wafer map that display a stronger indication that the wafer should or should not be in the sub-set than other areas of the yield wafer map. For example, the pattern shown in the yield wafer map 604 and highlighted as 610 is similar to the pattern 612 seen in the common characteristic data 604. The pattern 612 is considered to be of greater significance to determining whether a wafer is correctly allocated to a set than other areas of the yield wafer map. In some exemplary arrangements, it may be determined that a particular pattern must, or must not, be present in a yield wafer map for it to be included in a sub-set. In cases where the human is unsure, such as with yield wafer map 606, that may be indicated.

In other arrangements, the reference data may comprise corresponding parameter data (in this case, yield data) from two further wafers, which may be wafers from the set of wafers. The two further wafers comprise a first wafer that has a yield data map exhibiting less separation from the common characteristics of a sub-set than a second wafer. In some arrangements, the first wafer may have a high probability of being correctly allocated to the sub-set (e.g. over 80%) and the second wafer may have a significantly lower probability of being correctly allocated to the sub-set (e.g. less than 20%), or may be outside the sub-set. This may be termed a 'triplet constraint that may be used by the machine learning algorithm. The human may be asked to identify the two wafers that have the most similar yield data.

The model is reconfigured 410 based on the pairwise or triplet constraints provided by the human. The reconfiguring of the model may be implemented in a number of different ways, which may depend on the model (or clustering algorithm) used to sort the wafers. Exemplary methods are provided below, although these are non-exhaustive and should not necessarily be construed as limiting:
- A k-means algorithm aims at minimizing an objective function, which may be termed a squared error function. Therefore, when constraints such as those mentioned above are added to a k-means algorithm, a penalty may be added to its objective function for violating the constraints.
- An algorithm based on metric learning uses "must links" to create a set of similar points and "cannot links" to create a set of dissimilar points and learns a new distance metric that satisfies the constraints. The same is true when using triplet constraints in that the algorithm creates an order similarity and tries to satisfy it.
- In spectral clustering, a similarity matrix A is defined, the entries of which represent the similarity of the data points of a cluster (or sub-set) and first k eigenvectors of the Laplacian matrix of A are then calculated. Those k eigenvectors are used to embed the data to a k-dimensional space. Now k-means can be used with clustering constraints.
- When using a metric learning algorithm, the constraints are used for constructing the similarity matrix A and a simple k-means algorithm is performed on the low dimensional space.
- In a triplet embedding (for triplet constraints), the model may learn a distance metric on a low dimensional space and it is guaranteed that the distance on the points in the low dimensional space is close reflects the given triplet constraint with high probability.
- A further approach for triplet constraints comprises using neural networks to optimize a loss function called "triplet-loss" that summarizes the constraints in a mathematical formula.

The reconfigured model may then be used in subsequent sorting of semiconductor wafers. In the example of Figure 4a, the reconfigured model is used to re-sort the previously sorted set of semiconductor wafers.

Referring to Figure 4b, a method of determining a new sub-set is shown. The new sub-set is determined based on input from a human in semi-supervised learning for the machine learning algorithm.

Steps 450-454 correspond to steps 400-404 respectively and are not discussed again here.

In step 456, wafers exhibiting parameter data (in this case, yield data) within an area of interest are identified. This identification may be made by a human, e.g. a yield engineer, based on their observations from the data-driven determination of the sub-sets and any issues currently being faced in the fab (e.g. shading pattern, process-related fingerprints etc.). In one example, a human may select an area of the wafer (e.g. a zone or field) that is of interest and then wafers may be identified that have a similar yield data pattern in that area. It is noted that the determination of an area of interest and the subsequent identification of wafers that might be allocated to a new sub-set is encompassed within the identification of wafers based on a probability that they have been allocated to the correct sub-set. That is, the identified wafers have a high probability of belonging to the new sub-set and so have a high probability of being allocated to the wrong sub-set by the model.

The yield data maps of the identified wafers are compared 458 to yield data maps for two further wafers. This may be done by a human, e.g. a yield engineer, and the comparison used in a semi-supervised machine learning algorithm.

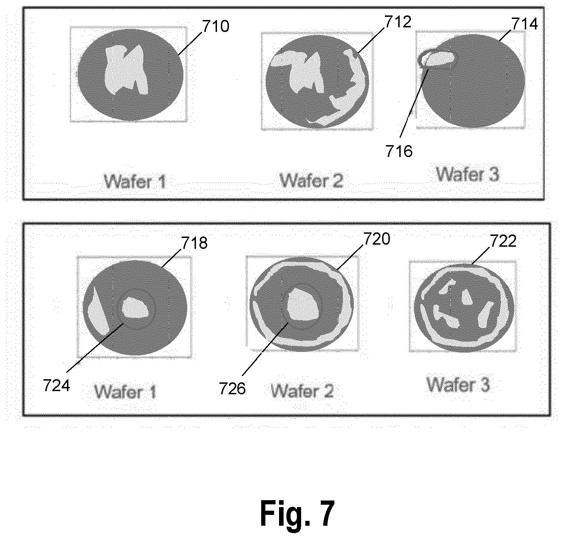

Figure 7 shows a schematic representation of a user interface for presenting the yield wafer maps of the three wafers to the human. In each row, the human is asked to identify the two wafers that have the most similar yield data. This may mean that the two wafers should both be allocated to the new sub-set.

In the first row, the human identifies, for example, that wafer 1 710 is closest to wafer 2 712. This may be because wafer 3 exhibits a yield data pattern having failures in the region identified at 716 and this is an area of interest to the human that is not seen in wafer 1 710 or wafer 2 712. Therefore, even though yield wafer maps of wafer 1 710 and wafer 2 714 look most similar based on the central region, wafer 1 710 does not include the pattern at 716 and so is closer to wafer 2 712.

In the second row, wafer 1 718 is determined to be closer to wafer 2 720 than to wafer 3 722 because of the common failure pattern in the centre of the yield wafer maps, shown by regions 724 and 726.

The information provided by the human in Figure 7 is conceptual and relies on prior knowledge of the human. It could not have been determined from the data alone.

Steps 460 and 462 correspond to steps 410 and 412 respectively and are not described again here.

A computer program may be configured to provide any of the above described methods. The computer program may be provided on a computer readable medium. The computer program may be a computer program product. The product may comprise a non-transitory computer usable storage medium. The computer program product may have computer-readable program code embodied in the medium configured to perform the method. The computer program product may be configured to cause at least one processor to perform some or all of the method.

Various methods and apparatus are described herein with reference to block diagrams or flowchart illustrations of computer-implemented methods, apparatus (systems and/or devices) and/or computer program products. It is understood that a block of the block diagrams and/or flowchart illustrations, and combinations of blocks in the block diagrams and/or flowchart illustrations, can be implemented by computer program instructions that are performed by one or more computer circuits. These computer program instructions may be provided to a processor circuit of a general purpose computer circuit, special purpose computer circuit, and/or other programmable data processing circuit to produce a machine, such that the instructions, which execute via the processor of the computer and/or other programmable data processing apparatus, transform and control transistors, values stored in memory locations, and other hardware components within such circuitry to implement the functions/acts specified in the block diagrams and/or flowchart block or blocks, and thereby create means (functionality) and/or structure for implementing the functions/acts specified in the block diagrams and/or flowchart block(s).

Computer program instructions may also be stored in a computer-readable medium that can direct a computer or other programmable data processing apparatus to function in a particular manner, such that the instructions stored in the computer-readable medium produce an article of manufacture including instructions which implement the functions/acts specified in the block diagrams and/or flowchart block or blocks.

A tangible, non-transitory computer-readable medium may include an electronic, magnetic, optical, electromagnetic, or semiconductor data storage system, apparatus, or device. More specific examples of the computer-readable medium would include the following: a portable computer diskette, a random access memory (RAM) circuit, a read-only memory (ROM) circuit, an erasable programmable read-only memory (EPROM or Flash memory) circuit, a portable compact disc read-only memory (CD-ROM), and a portable digital video disc read-only memory (DVD/Blu-ray).

The computer program instructions may also be loaded onto a computer and/or other programmable data processing apparatus to cause a series of operational steps to be performed on the computer and/or other programmable apparatus to produce a computer-implemented process such that the instructions which execute on the computer or other programmable apparatus provide steps for implementing the functions/acts specified in the block diagrams and/or flowchart block or blocks.

Accordingly, the invention may be embodied in hardware and/or in software (including firmware, resident software, micro-code, etc.) that runs on a processor, which may collectively be referred to as "circuitry," "a module" or variants thereof.

It should also be noted that in some alternate implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated.

An apparatus may be configured to undertake any of the methods disclosed herein. In particular, a lithographic apparatus may be configured to undertake any of the methods disclosed herein. In addition, a litho-cell may comprise such a lithographic apparatus.

Further embodiments of the invention are disclosed in the list of numbered clauses below:
1. A method for classifying semiconductor wafers, the method comprising:
   sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics;
   identifying one or more semiconductor wafers within a sub-set based on a probability of the one or more semiconductor wafers being correctly allocated to the sub-set;
   comparing the parameter data of the one or more identified semiconductor wafers to reference parameter data; and
   reconfiguring the model based on the comparison.
2. The method according to clause 1, further comprising re-sorting at least part of the set of semiconductor wafers based on the reconfigured model.
3. The method according to clause 1 or 2, wherein the reference parameter data comprises the common characteristics of the parameter data associated with the sub-set and/or parameter data of one or more further semiconductor wafers in the set of semiconductor wafers.
4. The method according to clause 3, wherein the reference data comprises the common characteristics of the parameter data associated with the sub-set, and wherein the comparison comprises identifying a part of the parameter data of the identified semiconductor wafers that provides a stronger indication that the identified semiconductor wafers should or should not be allocated to the sub-set than at least one further part of the parameter data.
5. The method according to clause 4, wherein the part of the parameter data wafers that provides a stronger indication comprises a part which must be present in the parameter data for an identified semiconductor wafer to be allocated to the sub-set and/or a part which must not be present in the parameter data for an identified semiconductor wafer to be allocated to the sub-set.
6. The method according to clause 4 or 5, wherein identifying the part of the parameter data comprises receiving an input from a human indicating whether the identified semiconductor wafers should be allocated to the sub-set.
7. The method according to any of clauses 3 to 6, wherein the reference data comprises the parameter data of two further semiconductor wafers in the set of semiconductor wafers.
8. The method according to clause 7, wherein the comparison comprises determining a separation between a sub-set of the parameter data of at least one of the one or more identified semiconductor wafers and corresponding sub-sets of the parameter data of the two further semiconductor wafers.
9. The method according to clause 8, wherein the comparison comprises determining a relative separation between the sub-set of the parameter data of the at least one of the one or more identified semiconductor wafers and the corresponding sub-sets of the parameter data of the two further semiconductor wafers.
10. The method according to clause 8 or 9, wherein the sub-set of the parameter data of the at least one of the one or more identified semiconductor wafers relates to a region and/or feature of interest of a semiconductor wafer.
11. The method according to any of clauses 7 to 10, wherein the comparison comprises receiving an indication from a human of which sub-set of the parameter data of the two further semiconductor wafers is closer to the sub-set of the parameter data of at least one of the one or more identified semiconductor wafers.
12. The method according to any of clauses 1 to 11, further comprising determining the probability of the one or more semiconductor wafers being correctly allocated to the sub-set.
13. The method according to clause 12, wherein determining the probability comprises determining a separation of at least part of the parameter data for a semiconductor wafer from the common characteristics of the sub-set.
14. The method according to clause 12 or 13, wherein the sub-set comprises a further sub-set.
15. The method according to any preceding clause, wherein the parameter data comprises yield data associated with a plurality of areas on the set of semiconductor wafers.
16. The method according to clause 15, wherein the yield data has been determined by sequentially undertaking a plurality of tests on the plurality of areas.
17. The method according to clause 16, wherein the yield data comprises data indicative of which of the plurality of tests has been passed and/or failed by the plurality of areas.
18. The method according to clause 16 or 17, wherein the yield data comprises data indicative of a repair density for one or more of the plurality of areas to pass one or more of the plurality of tests.
19. The method according to any of clauses 15 to 18, wherein the common characteristics comprise a common yield data pattern relating to the plurality of areas on at least part of the semiconductor wafer.
20. The method according to clause 19, wherein the common yield data pattern corresponds to a yield data pattern of at least a threshold number of the set of semiconductor wafers.
21. The method according to clause 19 or 20, wherein the common yield data pattern corresponds to a yield data pattern of a semiconductor wafer in the set of semiconductor wafers if a separation of the common yield data pattern from the yield data pattern is less than a threshold separation value.
22. The method according to any of clauses 15 to 21, wherein the areas comprise one or more dies.
23. The method according to any preceding clause, wherein the model is arranged to determine the plurality of sub-sets and/or the common characteristics of a sub-set based on the parameter data.
24. The method according to any preceding clause, wherein the model comprises a machine learning algorithm.
25. A method according to any preceding clause, wherein the comparing is undertaken by human.
26. A computer program comprising instructions which, when executed on at least one processor, cause the at least one processor to control an apparatus to carry out the method according to any of clauses 1 to 25.
27. A carrier containing the computer program of clause 26, wherein the carrier is one of an electronic signal, optical signal, radio signal, or non-transitory computer readable storage medium.
28. An apparatus for classifying semiconductor wafers, the apparatus comprising one or more processors configured to execute computer program code to undertake the method of:
   sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics;
   identifying one or more semiconductor wafers within a sub-set based on a probability of the one or more semiconductor wafers being correctly allocated to the sub-set;
   comparing the parameter data of the one or more identified semiconductor wafers to reference parameter data; and
   reconfiguring the model based on the comparison.
29. A lithographic apparatus comprising the apparatus according to clause 28.
30. A litho-cell comprising the lithographic apparatus according to clause 29.

The skilled person will be able to envisage other embodiments without departing from the scope of the appended claims.

## Claims

1. A method for classifying semiconductor wafers, the method comprising:
sorting a set of semiconductor wafers, using a model, into a plurality of sub-sets based on parameter data corresponding to one or more parameters of the set of semiconductor wafers, wherein the parameter data for semiconductor wafers in a sub-set include one or more common characteristics;
identifying one or more semiconductor wafers within a sub-set based on a probability of the one or more semiconductor wafers being correctly allocated to the sub-set;
comparing the parameter data of the one or more identified semiconductor wafers to reference parameter data; and
reconfiguring the model based on the comparison.

2. The method according to claim 1, further comprising re-sorting at least part of the set of semiconductor wafers based on the reconfigured model.

3. The method according to claim 1 or 2, wherein the reference parameter data comprises the common characteristics of the parameter data associated with the sub-set and/or parameter data of one or more further semiconductor wafers in the set of semiconductor wafers.

4. The method according to claim 3, wherein the reference data comprises the common characteristics of the parameter data associated with the sub-set, and wherein the comparison comprises identifying a part of the parameter data of the identified semiconductor wafers that provides a stronger indication that the identified semiconductor wafers should or should not be allocated to the sub-set than at least one further part of the parameter data.

5. The method according to claim 4, wherein the part of the parameter data wafers that provides a stronger indication comprises a part which must be present in the parameter data for an identified semiconductor wafer to be allocated to the sub-set and/or a part which must not be present in the parameter data for an identified semiconductor wafer to be allocated to the sub-set.

6. The method according to claim 4 or 5, wherein identifying the part of the parameter data comprises receiving an input from a human indicating whether the identified semiconductor wafers should be allocated to the sub-set.

7. The method according to any of claims 3 to 6, wherein the reference data comprises the parameter data of two further semiconductor wafers in the set of semiconductor wafers.

8. The method according to claim 7, wherein the comparison comprises determining a separation between a sub-set of the parameter data of at least one of the one or more identified semiconductor wafers and corresponding sub-sets of the parameter data of the two further semiconductor wafers.

9. The method according to claim 8, wherein the comparison comprises determining a relative separation between the sub-set of the parameter data of the at least one of the one or more identified semiconductor wafers and the corresponding sub-sets of the parameter data of the two further semiconductor wafers.

10. The method according to claim 8 or 9, wherein the sub-set of the parameter data of the at least one of the one or more identified semiconductor wafers relates to a region and/or feature of interest of a semiconductor wafer.

11. The method according to any of claims 7 to 10, wherein the comparison comprises receiving an indication from a human of which sub-set of the parameter data of the two further semiconductor wafers is closer to the sub-set of the parameter data of at least one of the one or more identified semiconductor wafers.

12. The method according to any of claims 1 to 11, further comprising determining the probability of the one or more semiconductor wafers being correctly allocated to the sub-set.

13. The method according to any preceding claim, wherein the parameter data comprises yield data associated with a plurality of areas on the set of semiconductor wafers.

14. The method according to any preceding claim, wherein the model comprises a machine learning algorithm.

15. The method according to any preceding claim, wherein the comparing is undertaken by human.
